# EUROPEAN PATENT APPLICATION

(11) **EP 2 230 677 A2**
(43) Date of publication of application: **22.09.2010**
(21) Application number: 10002344.9
(22) Date of filing: 08.03.2010
(51) Int. Cl.: H01G 9/20, H01L 31/00

(54) **Method and apparatus for production of dye-sensitized solar cells (DSSC)**

(30) Priority: 13.03.2009 KR 20090021406
(71) Applicant: DMS Co., Ltd., Youngtong-dong, Yeongtong-gu Suweon, Gyeonggi-do 443-470 (KR); TG-Energy Inc., Songpa-gu, 138-160 Seoul (KR)
(72) Inventor: Park, Chung-Seong, Yeongtong-gu Suweon Gyeonggi-do 443-725 (KR); Kim,Jong Min, Suweon Gyeonggi-do 443-470 (KR); Hwang, Jung Min, Suweon Gyeonggi-do 443-813 (KR); Kim, Gang-Beom, Cheonan Chungcheongnam-do 330-807 (KR); Eum, Jeong-Yong, Cheonan Chungcheongnam-do 361-793 (CN); Cho, Hyun-Seung, Daegu 706-906 (KR)
(74) Representative: Lacey, Dean Andrew

(57) **Abstract**

The present invention relates to a novel method and apparatus for the production of dye-sensitized solar cells (DSSC). According to the present invention, after the pre-transparent electrode on which the dye molecules are not adsorbed and the opposite electrode are bonded to each other, the photosensitive dye molecules are adsorbed onto the bonded electrode substrates. Thus, since the heat treatment prior to adsorption of the dye molecules hardly has an effect on the performance of a solar cell, it is not required to control the conditions for production of the solar cell, resulting in an increase in process efficiency. Furthermore, since the dye molecules adsorbing step, the washing step and electrolyte injecting step are carried out in the same equipment, effects of simplification of the process and reduction in the manufacturing time can be achieved.

## Description

### BACKGROUND

### (a) Technical Field

The present invention relates to a novel method and apparatus for the production of dye-sensitized solar cells (DSSC).

### (b) Backgtound Art

Depletion and sharp rise in price of fossil fuels, and drastic change in global climate change requires sustainable energy acquisition technologies. Among them, solar energy is the most spotlighted by virtue of infinite purity and safety.

Conventionally, a silicon type solar cell is studied widely and is utilized industrially, but still involves a problem in that it is high in manufacturing cost and low in economic efficiency. Recently, research into dye-sensitized cells (DSSC) as next-generation solar cells is actively in progress which is low in production cost while having energy conversion efficiency comparable to such a silicon solar cell.

In general, the DSSC is composed of a semiconductor electrode (also, referred to as "transparent electrode") in which a transparent conductive substrate is coated with porous oxide nanoparticles onto which photosensitive dye molecules are adsorbed, an electrode (also, referred to as, "opposite electrode") which is opposite (i.e. facing) the transparent electrode and in which a transparent conductive substrate is coated with platinum or carbon, an electrolyte layer filled in a space defined therebetween. The dye molecules serve to absorb solar light and create electron-hole pairs.

A conventional DSSC is produced through a schematic producing method comprising the following steps of: (1) fabricating a transparent electrode; (2) fabricating an opposite electrode; (3) laminating and bonding the transparent electrode and the opposite electrode so as to allow a predetermined interval (i.e. distance) to be maintained therebetween; (4) filling an electrolyte layer in the space defined between the two electrodes; and (5) hermetically sealing the bonded electrodes. Of course, a circuit for energization is properly designed depending on the structure and characteristics of a cell.

In this case, the transparent electrode is fabricated by the following method comprising the steps of: (a) coating porous oxide (for example, TiO₂) nanoparticles on a transparent conductive substrate (a transparent electrode before adsorption of photosensitive dye molecules onto oxide nanoparticles is called "pre-transparent electrode in the present invention); (b) immersing the coated substrate of the pre-transparent electrode in a dye solution in which photosensitive dye molecules are dissolved in a suitable concentration and fixing the substrate in the dye solution; and (c) taking the pre-transparent electrode substrate out of the dye solution, and washing and drying the pre-transparent electrode substrate.

As a result of examination in terms of adsorption of the dye molecules, the above-mentioned conventional prior art entails the following problems.

First, since the pre-transparent electrode substrate is soaked and fixed in the dye solution, followed by washing/drying, the fabrication process is complicated and the fabrication time is increased. In addition, since the entire substrate has to be immersed in the dye solution, a considerable amount of dye solution exceeding an actually needed amount is always used, which results in a waste of materials and requires a larger equipment (solution tank).

Second, since the dye molecules are adsorbed onto the oxide nanoparticles due to the fact that the substrate is merely immersed in the dye solution, much time is needed to sufficiently adsorb the dye molecules onto the oxide nanoparticles.

Third, there is a possibility that the adsorbed dye molecules will be separated from the substrate by a shock or a scratch during a process of moving (or manipulating) the transparent electrode to laminate the transparent electrode and the opposite electrode. In addition, it is necessary that a high-temperature treatment should be performed entirely or locally in a process of bonding the transparent electrode and the opposite electrode by laminating them together. However, a part of the dye molecules is decomposed at high temperature, so that its function is lost.

### SUMMARY OF THE INVENTION

Accordingly, the present invention has been made to solve the above-mentioned problems occurring in the prior art, and it is an object of the present invention to provide a novel method for producing a dye-sensitized solar cell (DSSC) which is excellent in an adsorption efficiency of dye molecules per unit time, is free of a waste of dye molecules, is simple in process, and can stably preserve and maintain the adsorbed dye molecules, and an apparatus for performing the same.

For achieving the above object, the present invention is directed to a method for producing a dye-sensitized solar cell (DSSC) which includes a semiconductor electrode (hereinafter, referred to as "transparent electrode") in which a transparent conductive substrate is coated with porous oxide nanoparticles onto which photosensitive dye molecules are adsorbed, an electrode (hereinafter, referred to as, "opposite electrode") which is opposite to (i.e. facing) the transparent electrode and in which a transparent conductive substrate is coated with platinum or carbon, and an electrolyte layer filled in a space defined therebetween, and an apparatus for performing the same.

Since the present invention is not directed to a specific constituent component or structure of a dye-sensitized solar cell (DSSC), the specific description of the kind of the substrate, the kind and properties of the oxide nanoparticles, the kind and properties of the sensitized dyes, the structure of the opposite electrode, the phase of the electrolyte, etc., will be omitted.

For the sake of clarification of the description, a transparent electrode before adsorption of photosensitive dye molecules onto oxide nanoparticles is called a "pre-transparent electrode", and a substrate in which the pre-transparent electrode and an opposite electrode are partially bonded is called a "pre-cell panel", respectively.

### Production Method of DSSC

A method for producing a dye-sensitized solar cell (DSSC) according to the present invention includes the steps of: (A) coating the oxide nanoparticles on the transparent conductive substrate and sintering the transparent conductive substrate, thus fabricating a pre-transparent electrode; (B) fabricating the opposite electrode; (C) symmetrically laminating the pre-transparent electrode substrate and the opposite electrode substrate in such a fashion as to be spaced apart by a predetermined interval (i.e. distance) from each other, and then bonding the two electrode substrates, wherein the electrode substrates have at least one opening, respectively, formed at both distal ends of a bonded portion thereof so as to allow the interior of the substrates to fluidly communicate with the outside; (D) allowing a photosensitive dye molecule solution to flow into the bonded electrode substrates through one of the openings formed at the distal ends of the bonded portion so as to adsorb dye molecules onto the oxide nanoparticles; (E) allowing a washing solution to flow into the bonded electrode substrates through one of the openings formed at the distal ends of the bonded portion upon the completion of the adsorption of the dye molecules so as to remove the remaining dye molecules which were not adsorbed onto the oxide nanoparticles; and (F) injecting electrolyte into the bonded electrode substrates through one of the openings upon the completion of the washing, and then closing both openings.

In step (D) of the present invention, the dye molecule solution may be circulated in a vertical direction including from the top to the bottom, or from the bottom to the top, or in a horizontal direction. In this case, preferably, the photosensitive dye molecule solution is caused to be circulated so as to prevent a waste of the dye molecule solution and enhance efficiency of the work. In addition, in the case of repeated circulation, it is preferable to constantly adjust the concentration of the dye molecules.

In the meantime, subsequent to step (E), it is preferable to allow dry hot air to circulatedly flow into the bonded electrode substrates through the openings to evaporate the washing solution, thereby removing the remaining washing solution within a short time period.

### Production Apparatus of DSSC

(1) An apparatus for performing the method for producing the dye-sensitized solar cell (DSSC) includes: (A) a solution supply unit adapted to supply a liquid to one side opening of the bonded electrode substrates; (B) a storage container adapted to store the liquid therein; and (C) a transfer tube and pump positioned between the storage container and the solution supply unit and adapted to transfer the liquid from the storage container to the solution supply unit.

In this case, the solution supply unit may be fabricated as a structure in which it corresponds to each substrate so as to simultaneously treat a plurality of bonded substrates.

In the present invention, preferably, the solution supply unit is constructed such that it has an inner cavity defined therein so as to fluidly communicate with the transfer tube, and an outer edge of one side opening of the bonded electrode substrates is closely adhered in an air-tight state.

In addition, the liquid may be a photosensitive dye molecule solution or a washing solution. In this case, the storage container is a photosensitive dye molecule solution storage container or a washing solution storage container. In this case, the photosensitive dye molecule solution is first supplied to the inside of the bonded substrates, and the washing solution is then supplied to the inside of the bonded substrates.

Meanwhile, it is possible to mount the bonded substrates in a separate tank (shield space), and allow the bottom of the tank to function as the storage container.

(2) Another apparatus for performing the method for producing the dye-sensitized solar cell (DSSC) includes: (A) a solution suction unit configured such that an outer edge of one side opening of the bonded electrode substrates is closely adhered in an air-tight state; (B) a solution supply unit adapted to supply liquid to other side opening of the bonded electrode substrates; (C) a storage container adapted to store the liquid therein; and (D) a transfer tube and pump adapted to transfer the liquid between the storage container and the solution supply unit. According to the present invention, liquid flows in such a fashion that a lower end of the bonded substrates is submerged in the liquid contained in the storage container, and the liquid is sucked upwardly to the solution suction unit.

In this case, the solution suction unit may be fabricated as a structure in which it corresponds to each substrate so as to simultaneously treat a plurality of bonded substrates.

In the present invention, preferably, the storage container is integrally formed to serve as the solution supply unit.

According to the present invention, after the pre-transparent electrode on which the dye molecules are not adsorbed and the opposite electrode are bonded to each other, the photosensitive dye molecules are adsorbed onto the bonded electrode substrates. Thus, since the heat treatment prior to adsorption of the dye molecules hardly has an effect on the performance of a solar cell, it is not required to control the conditions for production of the solar cell, resulting in an increase in process efficiency. Furthermore, since the dye molecules adsorbing step, the washing step and electrolyte injecting step are carried out in the same equipment, effects of simplification of the process and reduction in the manufacturing time can be achieved

(1) In a conventional method of immersing the coated substrate of the pre-transparent electrode in a dye solution, it is required that the adsorption of the dye molecules be performed for 12-24 hours. On the other hand, according to the present invention, the adsorption of the dye molecules is completed within just 2-4 hours. (2) Since the dye adsorbing step and the washing step can be carried out in a single equipment, and these steps are directly associated with the electrolyte injecting step, the mass-production of the DSSC by the in-line process is enabled. (3) Adsorption of dye molecules is conducted after the heat treatment or the like, thereby leading to an increase in stability of the dye, and hence improvement of the efficiency of the solar cell.

### BRIEF DESCRIPTION OF THE DRAWINGS

The above and other objects, features and advantages of the present invention will be apparent from the following detailed description of the preferred embodiments of the invention in conjunction with the accompanying drawings, in which:

FIG. 1 is a flowchart illustrating a process of producing a dye-sensitized solar cell (DSSC) according to the present invention;

FIGs. 2 and 3 are conceptual views illustrating the construction and operating state of a DSSC production apparatus according to the present invention; and

FIGs. 4a to 4c are conceptual views illustrating the DSSC production apparatus manufactured in the shape of a jig.

### DETAILED DESCRIPTION OF EMBODIMENTS

Hereinafter, the present invention will be described in further detail with reference to the accompanying drawings and examples. It is to be understood, however, that these drawings and examples are for illustrative purposes only and are not to be construed to limit or change the scope of the present invention. It will be obvious to a person skilled in the art that other various modifications and variations are possible within the scope of the present invention.

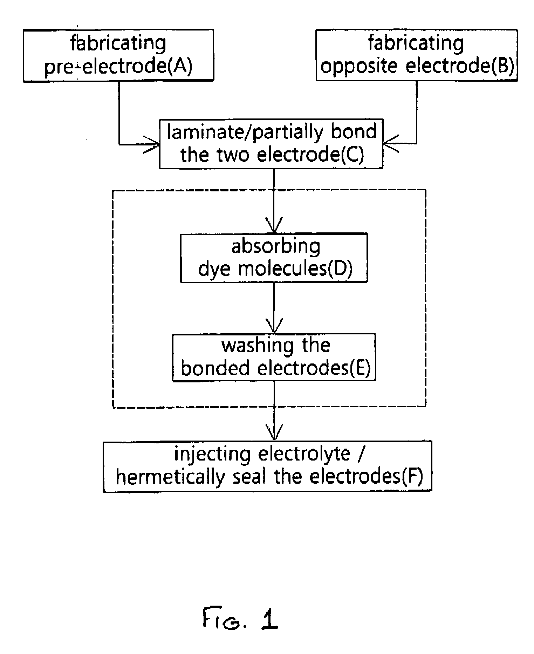

FIG. 1 is a flowchart illustrating a process of producing a dye-sensitized solar cell (DSSC) according to the present invention.

As shown in FIG. 1, the present invention includes the following steps of: (A) fabricating a pre-transparent electrode; (B) fabricating an opposite electrode; (C) laminating and partially bonding the pre-transparent electrode and the opposite electrode; (D) adsorbing dye molecules; (E) washing the inner surfaces of the pre-transparent electrode and the opposite electrode; (F) injecting electrolyte between the bonded electrodes and hermetically sealing the bonded electrodes. In this case, the present invention may further include, between step (E) and step (F), a step of supplying dry air to wash the inner surfaces between the pre-transparent electrode and the opposite electrode.

The transparent electrode used in producing the DSSC has a structure in which a transparent electrical conductive film and a porous oxide nanoparticle layer 13 are laminated on a transparent substrate 11 in this order, and photosensitive dye molecules are adsorbed onto the surface of the oxide nanoparticle layer. Formation of the porous oxide nanoparticle layer 13 and the adsorption of the photosensitive dye are carried out in a conventional transparent electrode, and are used in a subsequent process.

On the other hand, in the present invention, an electrode (i.e., pre-transparent electrode) in which the photosensitive dye molecules are not adsorbed onto the oxide nanoparticle layer is used in a subsequent process.

Meanwhile, in the DSSC, it is very important that the pair of substrates are hermetically sealed completely at the outer edges thereof in a state of being spaced apart by a predetermined interval from each other in order to prevent leakage of electrolyte filled between the pair of substrates and introduction of external air or moisture into the substrate pairs. To this end, conventionally, a bonding agent such as a thermoplastic resin film, a thermosetting or UV curable resin, a glass paste composition or the like is applied between the pair of substrates using a suitable method, and the pair of substrates are hermetically sealed through UV irradiation, laser radiation or the like.

In the above laminating and partially bonding step (C) of the present invention, a bonding agent is taped to or coated on any one of the two electrode substrates according to a designed solar cell pattern, and then the other substrate is symmetrically laminated on the one side substrate. Subsequently, the two substrates are bonded to each other through heat treatment, UV irradiation, laser radiation or the like (this is the same as the conventional method). In this case, at least one opening is formed at both distal ends of the bonded portion, respectively, so as to allow the interior of the substrates to fluidly communicate with the outside. Of course, it is natural that the size (length) of the opening can be changed arbitrarily depending on the work environment. The opening may be obtained by having a hole formed at a hermetically sealed substrate or a bonded portion through a suitable physicochemical method. Alternatively, it is preferable that a bonding agent is not applied to a portion where the opening will be formed so that the opening is formed naturally.

In this manner, through the above laminating and partially bonding step (C), a substrate in which the pre-transparent electrode and the opposite electrode are partially bonded is called a "pre-cell panel 10". In this case, at least one opening is formed at both distal ends of the bonded portion.

In the present invention, the step (D) of adsorbing dye molecules is a step in which a photosensitive dye molecule solution is injected into the inside of the substrates through one side opening of the pre-cell panel 10 and is discharged to the outside through the other side opening. To prevent a waste of materials, it is preferable that the dye molecule solution is not allowed to flow to a location other than the opening. For example, preferably, the pre-cell panel 10 has a structure in which an outer edge of one side opening of the bonded pre-cell panel 10 is closely adhered in an air-tight state to prevent the dye molecule solution from flowing to a location other than the inner cavity of the pre-cell panel 10 in a state in which the pre-cell panel 10 is disposed upright. The dye molecule solution is caused to flow from the top to the bottom, or vice-versa using a pump 50, a dispenser or a vacuum pump 50. As a result of a pre-experiment, it was found that when a dye molecule solution of a typical concentration is circulated for 2-4 hours, dye molecules are saturatedly adsorbed onto a porous oxide nanoparticle layer.

When the adsorption of the dye molecules is complete, the subsequent washing step (E) is performed in which a washing solution instead of the dye molecule solution is supplied (replacement of a solution tank 41)

Thereafter, the step (F) of injecting electrolyte between the bonded electrodes and hermetically sealing the bonded electrodes is carried out according to a conventional known method. For the sake of convenience of injection, immediately before the electrolyte is injected, a part of the opening may be previously sealed.

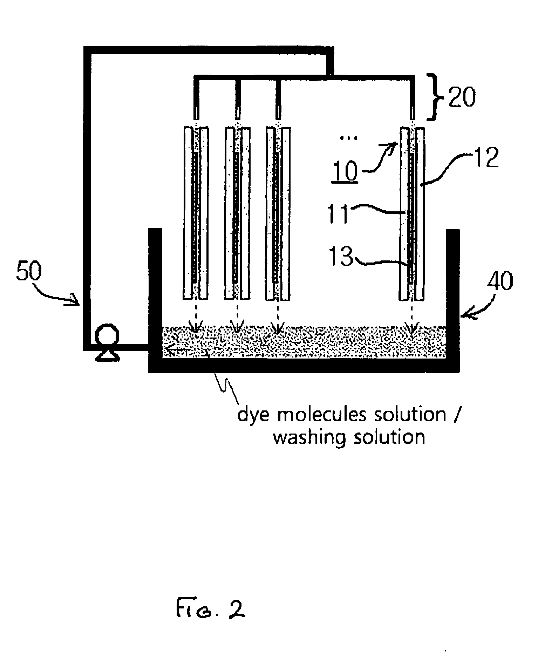

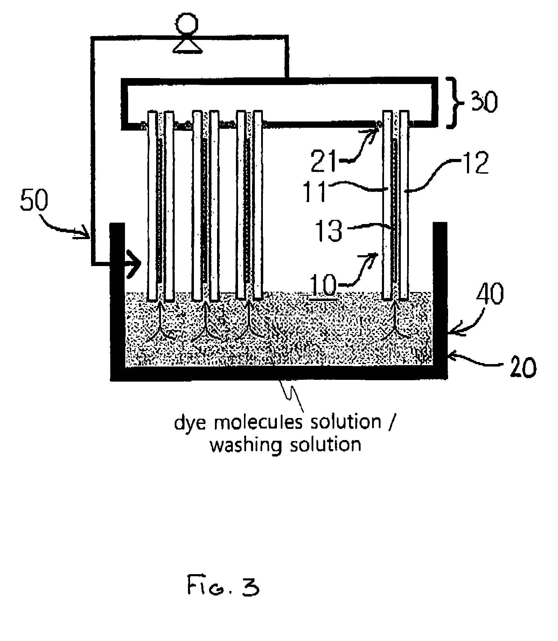

FIGs. 2 and 3 are conceptual views illustrating the construction and operating state of a DSSC production apparatus according to the present invention.

The apparatus of FIG. 2 is constructed such that a dye molecule solution (or a washing solution) flows from the top to the bottom. The apparatus includes a solution supply unit 20 adapted to supply a dye molecule solution (or a washing solution) to an upper opening of an upright pre-cell panel 10, a storage container 40 adapted to store the dye molecule solution (or the washing solution), and a transfer tube and pump 50 adapted to transfer the dye molecule solution (or the washing solution) from the storage container 40 to the solution supply unit 20. Of course, it is obvious that although not shown, an arbitrary support means is provided to align and hold the pre-cell panel 10.

The apparatus of FIG. 3 is constructed such that a dye molecule solution (or a washing solution) flows from the bottom to the top. Of course, it may be an apparatus having the same concept as that of the apparatus of FIG. 3 so that the dye molecule solution (or the washing solution) can be circulated from the top to the bottom.

The apparatus includes a solution suction unit 30 having an inner cavity defined therein and adapted to be configured such that an outer edge of an upper opening of a pre-cell panel 10 is closely adhered water-tightly, a solution supply unit 20 adapted to supply a dye molecule solution (or a washing solution) to a lower opening of the pre-cell panel 10 so that the lower opening of the pre-cell panel 10 is submerged in the dye molecule solution (or the washing solution), a storage container 40 adapted to store the dye molecule solution (or the washing solution), and a transfer tube and pump 50 adapted to transfer the dye molecule solution (or the washing solution) between the storage container 40 to the solution supply unit 20. In this case, a water-tight adhesion between the pre-cell panel 10 and the solution suction unit 30 can be performed by allowing the pre-cell panel 10 and the solution suction unit 30 to be pressingly fixed to each other with a water-tight means 21 such as a rubber or silicon strip or the like having a resistant property against the dye molecule solution (or the washing solution) interposed therebetween. Also, of course, it is obvious that although not shown, an arbitrary support means is provided to align the pre-cell panel 10 and pressingly fix the pre-cell panel 10 and the solution suction unit 30.

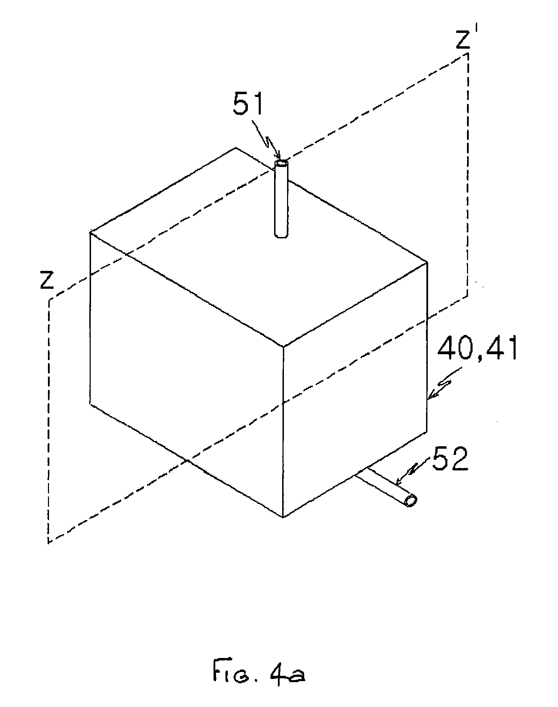

FIGs. 4a to 4c show a part of the DSSC production apparatus according to the present invention.

The DSSC production apparatus of FIG. 4a to 4c is constructed such that a dye molecule solution (or a washing solution) is circulated from the top to the bottom. Of course, it may be an apparatus having the same concept as that of the apparatus of FIGs. 4a to 4c so that the dye molecule solution (or the washing solution) can be circulated from the bottom to the top.

FIG. 4a is a perspective view of the DSSC production apparatus according to the present invention.

In FIG. 4a, although not shown, a tank 41 having a predetermined opening and closing means functions to include solution suction unit 30 and the pre-cell panel 10 built therein while serving as a storage container 40 containing a dye molecule solution (or a washing solution). A solution injection tube 51 and a solution discharge tube 52 are shown as a part of the transfer tube and pump 50, and a pump 50 is not shown.

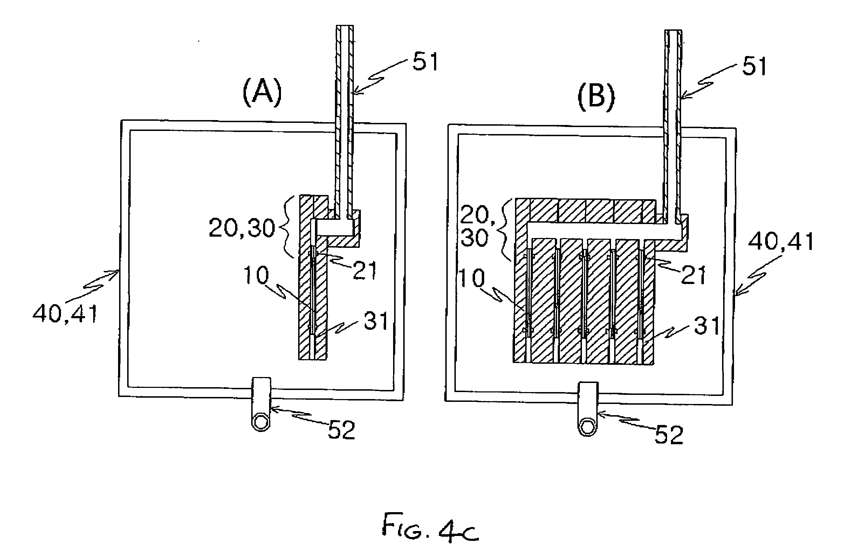

FIG. 4c is a cross-sectional view taken along a plane passing along a line Z-Z' of FIG. 4a. FIG. 4c(A) shows a state in which a single pre-cell panel 10 is mounted within the storage container 40, and FIG. 4c(B) shows a state in which a plurality of pre-cell panels 10 is mounted within the storage container 40, respectively.

The solution supply unit 20 is constructed in the shape of a prefabricated jig so that a pre-cell panel 10 is assembled between a jig 31 and a jig 31 in such fashion as to be closely adhered in a water-tight state. A water-tight adhesion between the pre-cell panel 10 and the jig 31, and between the jig 31 and the jig 31 can be performed by allowing the pre-cell panel 10 and the solution suction unit 30 to be pressingly fixed to each other with a water-tight means 21 such as a rubber or silicon strip or the like having a resistant property against the dye molecule solution (or the washing solution) interposed therebetween. Also, of course, it is obvious that although not shown, an arbitrary support means is provided to align the pre-cell panel 10 with the jigs 31 and pressingly fix the pre-cell panel 10 and the jigs 31.

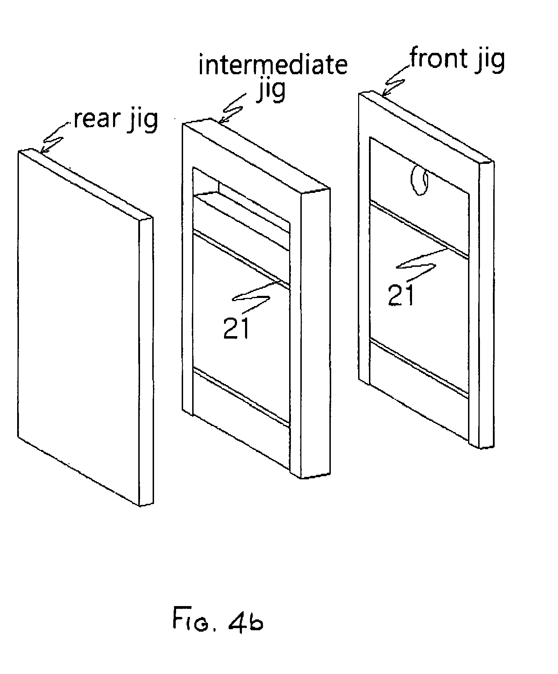

In this apparatus, the jig 31 may include, for example, a front jig, a rear jig and an intermediate jig, which are shown in FIG. 4b. The front jig 31 has an opening formed at an upper portion thereof so as to fluidly communicate with the solution injection tube 51, and the intermediate jig 31 has an aperture formed at an upper portion thereof, so as to form an inner cavity when all jigs are assembled. On the contrary, the rear jig 31 is not formed with any aperture since it must serve as an outer partition wall to allow an inner cavity to be defined when the jigs are assembled.

FIG.4c is a cross-sectional view illustrating a state in which the jigs 31 and the pre-cell panels 10 are assembled in such fashion as to be closely adhered to each other in a water-tight state.

According to the DSSC production apparatus, when the dye molecule solution (or the washing solution) is pressurizingly introduced into a space of an upper end of the assembled jigs 31, the solution flows to an opening at a lower end of the pre-cell panel 10 via the inside of the pre-cell panel 10 through an opening at an upper end of the pre-cell panel 10 owing to the water-tight adhesion between the jig 31 and the jig 31 and between the jig 31 and the pre-cell panel 10. In this process, the dye molecules are effectively adsorbed onto the oxide nanoparticle layer (dye molecule adsorbing step) or the remaining dye molecules are washed (washing step).

Finally, electrolyte is injected into the pre-cell panel 10 and the opening is hermetically sealed according to a typical method, thereby completing the dye-sensitized solar cell (DSSC).

While the present invention has been described with reference to the particular illustrative embodiments, it is not to be restricted by the embodiments but only by the appended claims. It is to be appreciated that those skilled in the art can change or modify the embodiments without departing from the scope of the present invention.

## Claims

1. A method for producing a dye-sensitized solar cell (DSSC) which includes a transparent electrode comprising a semiconductor electrode in which a transparent conductive substrate is coated with porous oxide nanoparticles onto which photosensitive dye molecules are adsorbed, an opposite electrode which is opposite the transparent electrode and in which a transparent conductive substrate is coated with platinum or carbon, and an electrolyte layer filled in a space defined therebetween, the method comprising the steps of:
(A) coating the porous oxide nanoparticles on the transparent conductive substrate and sintering the transparent conductive substrate, thus fabricating a pre-transparent electrode;
(B) fabricating the opposite electrode;
(C) symmetrically laminating the pre-transparent electrode substrate and the opposite electrode substrate in such a fashion as to be spaced apart from each other by a predetermined interval, and then bonding the two electrode substrates, wherein the electrode substrates have at least one opening, respectively, formed at both distal ends of a bonded portion thereof so as to allow the interior of the substrates to fluidly communicate with the outside;
(D) allowing a photosensitive dye molecule solution to flow intro the interior of the bonded electrode substrates through one of the openings formed at the distal ends of the bonded portion so as to adsorb dye molecules onto the oxide nanoparticles;
(E) allowing a washing solution to flow into the interior of the bonded electrode substrates through one of the openings formed at the distal ends of the bonded portion upon the completion of the adsorption of the dye molecules, so as to remove the remaining dye molecules which were not adsorbed onto the oxide nanoparticles; and
(F) injecting electrolyte into the interior of the bonded electrode substrates through one of the openings upon completion of the washing step, and then closing both of the openings.

2. A method according to claim 1, wherein in step (D), the photosensitive dye molecule solution is circulated.

3. A method according to claim 2, wherein the step of circulating the photosensitive dye molecule solution comprises injecting the solution into the interior of the bonded electrode substrates through one of the openings and discharging the solution from the interior of the bonded electrode substrates through the other opening.

4. A method according to any preceding claim, further comprising allowing dry hot air to circulatedly flow into the interior of the bonded electrode substrates through the openings to remove the remaining washing solution after step (E).

5. An apparatus for performing the method according to any one of claims 1 to 4, comprising:
a solution supply unit (20) adapted to supply a liquid to one of the openings of the bonded electrode substrates;
a storage container (40) adapted to store the liquid therein; and
a transfer tube and pump (50) positioned between the storage container (40) and the solution supply unit (20) and adapted to transfer the liquid from the storage container (40) to the solution supply unit (20).

6. An apparatus according to claim 5, wherein the solution supply unit (20) includes an inner cavity defined therein so as to fluidly communicate with the transfer tube, and an outer edge of one side opening of the bonded electrode substrates is closely adhered with the inner cavity in an air-tight state.

7. An apparatus according to claim 5 or 6, wherein the liquid is a photosensitive dye molecule solution or a washing solution.

8. An apparatus according to any of claims 5 to 7, wherein the bonded electrode substrates are mounted within a tank (41) whose bottom serves as the storage container (40).

9. An apparatus for performing the method according to any one of claims 1 to 4, comprising:
a solution suction unit (30) configured such that an outer edge of one side of the bonded electrode substrates having one of the openings is closely adhered in an air-tight state with the solution suction unit (30);
a solution supply unit (20) adapted to supply liquid to the other opening of the bonded electrode substrates;
a storage container (40) adapted to store the liquid therein; and
a transfer tube and pump (50) adapted to transfer the liquid between the storage container (40) and the solution supply unit (20).

10. An apparatus according to claim 9, wherein the storage container (40) serves as the solution supply unit (20).
